(19) Europäisches Patentamt

European Patent Office

Office européen des brevets

(11) **EP 1 677 352 A2**

(12) **DEMANDE DE BREVET EUROPEEN**

(43) Date de publication:
**05.07.2006 Bulletin 2006/27**

(51) Int Cl.:
*H01L 27/092* (2006.01)    *H03F 3/45* (2006.01)

(21) Numéro de dépôt: **05112404.8**

(22) Date de dépôt: **19.12.2005**

(84) Etats contractants désignés:
**AT BE BG CH CY CZ DE DK EE ES FI FR GB GR HU IE IS IT LI LT LU LV MC NL PL PT RO SE SI SK TR**
Etats d'extension désignés:
**AL BA HR MK YU**

(30) Priorité: **20.12.2004  FR 0413606**

(71) Demandeur: **ATMEL NANTES SA**
**44306 Nantes Cédex 3 (FR)**

(72) Inventeurs:
• **Gibet , Stanislas**
**44470, CARQUEFOU (FR)**

• **Bendraoui, Abdellatif**
**44450, SAINT-JULIEN DE CONCELLES (FR)**
• **Mercier, Gilles**
**44470, CARQUEFOU (FR)**

(74) Mandataire: **Guéné, Patrick Lucien Juan Joseph**
**Cabinet Vidon**
**Technopole Atalante**
**16B, rue de Jouanet**
**BP 90333**
**F-35703 Rennes Cedex 7 (FR)**

(54) **Circuit semi-conducteur**

(57)    L'invention concerne un circuit électronique (60) comprenant au moins une première paire différentielle (61) comprenant des premier (611) et second transistors (612).

Selon l'invention, dans un tel circuit lesdits premier (611) et second (612) transistors partagent une même source unique ou un même drain unique (614).

Fig. 6

EP 1 677 352 A2

**Description**

**1. Domaine de l'invention**

Le domaine de l'invention est celui des circuits électroniques intégrés et plus particulièrement celui de la conception de circuits intégrés.

Plus précisément, l'invention concerne l'optimisation de la topologie de circuits intégrés, et notamment l'optimisation de la topologie des oscillateurs commandés en tension (notés VCO pour « Voltage Controlled Oscillator »).

**2. Solutions de l'art antérieur**

Un oscillateur commandé en tension a pour fonction de générer en sortie un signal périodique dont la fréquence est fonction d'une tension continue appliquée en une entrée. Il permet ainsi de générer des signaux périodiques dont on peut choisir la fréquence.

Il existe plusieurs types d'oscillateurs commandés en tension. Un premier exemple de VCO est le VCO de type RC qui est basé sur la charge et la décharge d'une capacité à travers un condensateur.

Un second exemple de VCO est l'oscillateur différentiel commandé en tension, désigné par VCO différentiel dans la suite. Le VCO différentiel comprend classiquement quatre paires différentielles à base de transistors.

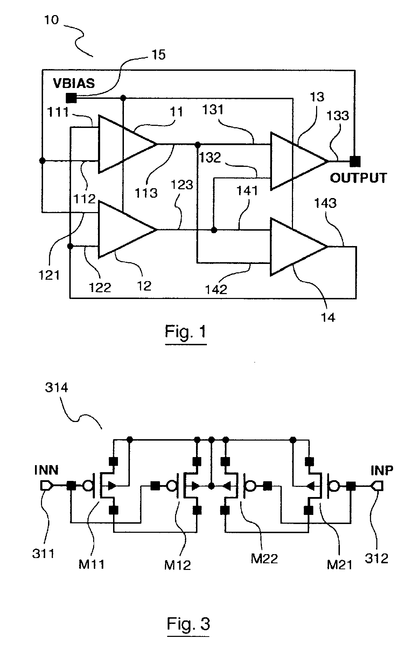

La *: figure 1* présente un schéma simplifié d'un VCO différentiel classique 10. Le VCO différentiel comprend des premier 11, second 12, troisième 13 et quatrième 14 étages d'amplification. Les étages d'amplification 11 à 14 sont polarisés au moyen d'une tension de polarisation VBIAS appliquée en une entrée 15 du VCO différentiel 10. Chaque étage comprend deux entrées, respectivement 111 et 112, 121 et 122, 131 et 132, 141 et 142, et une sortie respectivement 113, 123, 133 et 143.

La sortie 133 du troisième étage fournit la tension de sortie périodique du VCO différentiel 10 dont la fréquence dépend de la tension de polarisation VBIAS.

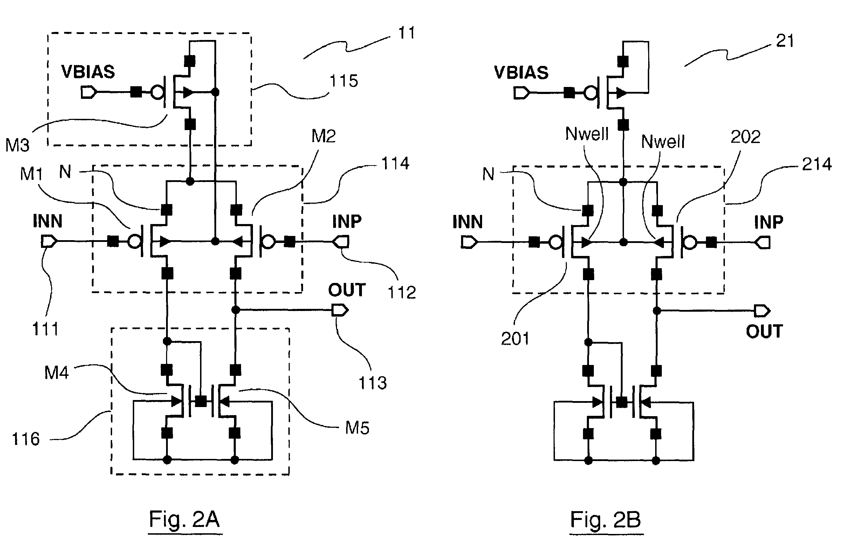

La **figure 2A** présente le schéma d'un étage d'amplification classique du VCO différentiel 10, par exemple le premier étage 11. Par exemple, tous les étages 11 à 14 du VCO différentiel 10 sont identiques.

Ce premier étage 11 comprend classiquement :

- une paire différentielle classique 114 à base de deux transistors MOS M1, M2 de type P ;
- une source de courant 115 comprenant un transistor MOS M3 de type P; et
- une charge active 116 à base de deux transistors MOS M4, M5 de type N.

Les entrées 111, 112 du premier étage 11 sont reliées aux grilles des transistors M1, M2 de la paire différentielle 114. La sortie 113 du premier étage 11 est connectée au drain du transistor M2 de la paire différentielle 114.

Les sources des transistors M1, M2 de la paire différentielle 114 sont reliées à un même noeud commun N.

Une technique connue (illustrée par la **figure 2B**) pour augmenter la réjection d'alimentation d'un étage d'amplification 21 est de connecter les caissons NWELL des transistors 201, 202 de la paire différentielle 214 à un noeud commun N.

Lors de la conception d'une paire différentielle comprenant deux transistors M1, M2, on peut classiquement remplacer chacun des transistors de la paire, par exemple le transistor M1, par deux transistors M11, M12 présentant chacun une largeur de grille deux fois plus petite et une longueur de grille identique à celle du transistor M1.

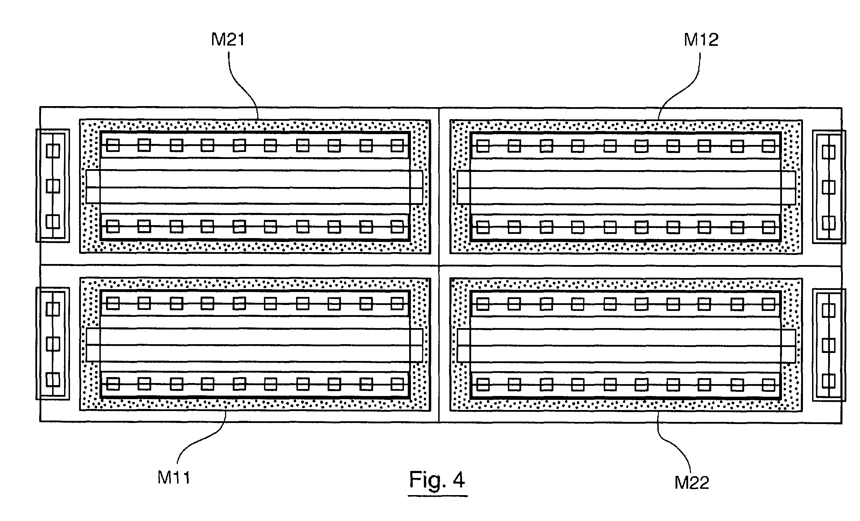

Ainsi, la **figure 3** présente le schéma d'une telle paire différentielle 314 dans laquelle chacun des transistors a été dédoublé de manière à former deux paires de transistors respectivement M11 et M12, M22 et M21. La **figure 4** est un schéma de la topologie des transistors M11, M12, M22 et M21 de la paire différentielle 314 de la figure 3 dans le cas d'une disposition en « paire croisée ». Plusieurs pistes métalliques (non représentées sur la figure 4) permettent de réaliser les connexions électriques de la figure 3 entre les différents contacts des transistors.

On peut noter que sur cette figure 4 mais également sur les suivantes, les zones marquées par des points noirs sont des zones dopées dans lesquelles les transistors sont réalisés.

Les 4 transistors de la paire différentielle 314 sont équivalents à deux transistors formant la paire 314. La disposition en « paire croisée » permet d'assurer une bonne uniformité des dimensions de ces deux transistors équivalents lors de la fabrication de la paire.

En effet, toute variation de dimension due au process de fabrication, ainsi que toute perturbation créant des effets parasite sur les transistors (bruit, variation de température,...) est répercutée de la même façon sur chacun de ces deux transistors équivalents.

Or, un manque d'uniformité sur les dimensions des transistors d'une paire différentielle (par exemple la paire 314 de la figure 3) génère un décalage en tension (ou « offset » en anglais) entre les deux entrées de la paire (311 et 312) qui risque de perturber le fonctionnement d'un étage d'amplification comprenant la paire.

Les spécialistes de la fabrication de transistors considèrent donc qu'il est nécessaire de mettre en oeuvre la disposition en « paires croisées » lors de la fabrication d'une paire différentielle.

Cependant, cette disposition génère des capacités parasites (capacités dues aux pistes métalliques qui relient les transistors, capacité de diffusion des transistors, capacité de surface ou de périmètre entre les caissons des transistors et le substrat,...) qui limitent les performances du VCO différentiel, notamment en réduisant sa fréquence d'oscillation.

Les VCOs peuvent fonctionner dans différentes gammes de fréquences et être réalisés suivant différentes technologies, chacune associée à un pas qui est généralement indiqué en microns.

La nécessité croissante de réduire la consommation et les dimensions des systèmes électroniques à base de circuits intégrés a conduit les concepteurs de tels VCO à utiliser des technologies de réalisation présentant un pas de plus en plus petit.

Ainsi, par exemple pour réaliser une boucle à verrouillage de phase (ou PLL pour Phase Locked Loop) pour un port USB selon la norme USB 2.0, on peut avoir besoin de réaliser des VCOs au moyen de technologies présentant un pas inférieur à $0,5\ \mu m$ et qui fonctionnent à une fréquence de l'ordre de 480 MHZ (pour une horloge interne de 12 MHz).

Généralement, les VCOs fonctionnant à hautes fréquences (supérieure à 300MHz) et réalisés à partir de technologies fines (inférieures à $0,5\ \mu m$) sont des VCO de type RC. En effet, l'Homme du Métier estime que si l'on voulait réaliser un VCO différentiel fonctionnant à ces fréquences à partir d'une technologie inférieure à $0,5\ \mu m$, les transistors des paires différentielles de ce VCO différentiel seraient trop petits pour assurer une bonne uniformité des dimensions des transistors du VCO malgré l'utilisation de la disposition en « paires croisées ».

## 3. Objectifs de l'invention

L'invention a notamment pour objectif de pallier ces inconvénients de l'art antérieur.

Plus précisément, un objectif de l'invention, dans au moins un de ses modes de réalisation, est de fournir un VCO différentiel fonctionnant à haute fréquence et réalisé dans une technologie très fine.

Un autre objectif de l'invention, dans au moins un de ses modes de réalisation, est de mettre en oeuvre un tel VCO qui soit performant et qui présente notamment une réduction des capacités parasites par rapport aux VCO classiques.

L'invention à également pour objectif de fournir un tel VCO qui nécessite un nombre d'étapes réduit lors de sa fabrication et qui occupe une faible surface de semiconducteur.

L'invention, dans au moins un de ses modes de réalisation, a encore pour objectif de mettre en oeuvre un tel VCO qui soit simple à réaliser et pour un faible coût.

## 4. Caractéristiques essentielles de l'invention

Ces objectifs, ainsi que d'autres qui apparaîtront par la suite, sont atteints à l'aide d'un circuit électronique comprenant au moins une première paire différentielle comprenant des premier et second transistors.

Selon l'invention, dans un tel circuit électronique, les premier et second transistors partagent une même source unique ou un même drain unique.

Ainsi, l'invention se propose d'aller à l'encontre des préjugés de l'Homme du Métier en proposant un circuit électronique à base de paires différentielles dont les transistors des paires différentielles ne sont pas disposés en « paire croisée » et qui peuvent donc ne pas présenter des dimensions uniformes.

Le principe général de l'invention repose sur la réalisation d'une paire différentielle comprenant un double transistor obtenu au moyen de deux transistors qui partagent une même source ou un même drain.

Ainsi, la mise en oeuvre de tels doubles transistors permet d'obtenir des circuits à base de paires différentielles présentant des capacités parasites et une surface de semiconducteur occupée nettement réduites par rapport aux circuits classiques.

Selon un premier mode de mise en oeuvre avantageux de l'invention, lesdits premier et second transistors sont des transistors MOS de type P et ils partagent un même drain unique.

Selon un second mode de mise en oeuvre avantageux de l'invention, lesdits premier et second transistors sont des transistors MOS de type N et en ce qu'ils partagent une même source unique.

Avantageusement, le circuit électronique comprend en outre au moins une seconde paire différentielle (62, 72), l'ensemble des transistors desdites première et au moins une seconde paires différentielles étant compris dans un caisson unique (76).

Ainsi, l'utilisation d'un caisson unique permet de réduire l'influence des capacités parasites de surface et de périmètre.

Préférentiellement, le circuit électronique comprend quatre étages d'amplification comprenant chacun au moins une desdites paires différentielles, l'ensemble des transistors desdites paires différentielles étant compris dans un caisson unique.

Selon une caractéristique avantageuse de l'invention, le circuit électronique est fabriqué au moyen d'une technologie dont le pas est inférieur à 0,5 $\mu$m.

Préférentiellement, le circuit électronique est un oscillateur différentiel commandé en tension.

Avantageusement, le circuit électronique est conçu pour fonctionner à une fréquence supérieure à 300MHz.

Ainsi, l'invention propose un VCO différentiel fonctionnant à des fréquences supérieures à 300MHZ et réalisé au moyen d'une technologie inférieure à 0,5 $\mu$m.

## 5. Liste des figures

D'autres caractéristiques et avantages de l'invention apparaîtront plus clairement à la lecture de la description suivante d'un mode de réalisation préférentiel, donné à titre de simple exemple illustratif et non limitatif, et des dessins annexés, parmi lesquels :

- la figure 1 présente un schéma simplifié d'un VCO différentiel classique à base de quatre étages d'amplification ;
- les figures 2A et 2B présentent deux schémas d'un étage d'amplification classique à base d'une paire différentielle du VCO différentiel de la figure 1;
- la figure 3 présente le schéma d'une paire différentielle classique réalisée à partir de quatre transistors ;
- la figure 4 est un schéma de la topologie des transistors de la paire différentielle de la figure 3 dans le cas d'une disposition en «paire croisée » ;
- la figure 5 est un schéma de la topologie des transistors d'un VCO différentiel classique comprenant 4 paires différentielles disposées en « paires croisées » ;
- la figure 6 est un schéma de la topologie des transistors d'un VCO différentiel selon un premier mode de réalisation de l'invention ;
- la figure 7 est un schéma de la topologie des transistors d'un VCO différentiel selon un second mode de réalisation de l'invention.

## 6. Description d'un mode de réalisation de l'invention

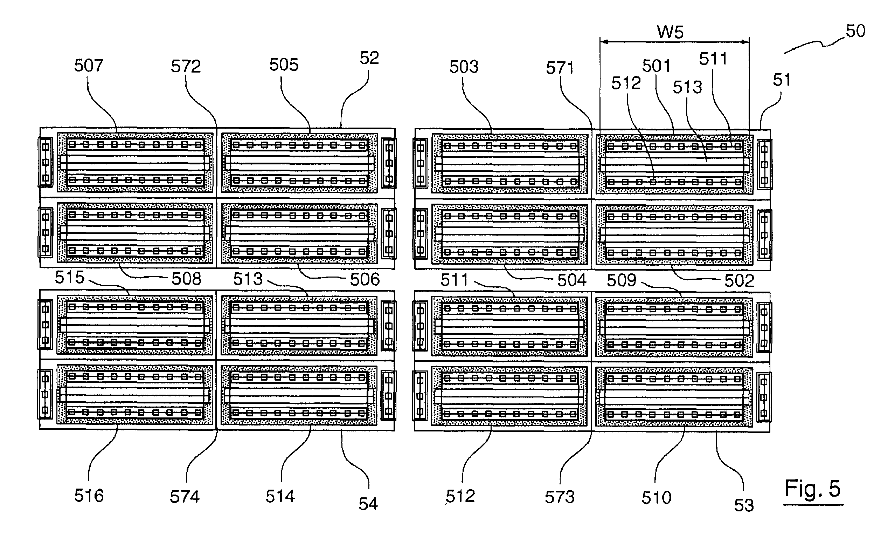

On présente, en relation avec la *figure 5,* la topologie d'un VCO différentiel 50 classique dont les transistors sont disposés « en paires croisées ».

Ce VCO 50 comprend seize transistors MOS de type P 501 à 516, formant des premiers 501, 505, 509, 513, seconds 502, 506, 510, 514, troisièmes 503, 507, 511, 515 et quatrièmes 504, 508, 512, 516 transistors de quatre paires différentielles 51 à 54 (les autres composant du VCO 50 ne sont pas représentés sur cette figure 5).

Les quatre transistors de chacune des paires différentielles 51 à 54 sont fabriqués dans un même caisson, respectivement 571, 572, 573, 574.

Par exemple, le premier transistor 501 de la paire différentielle 51 du VCO 50 possède une source 5011, un drain 5012 et une grille 5013.

Les quatre paires différentielles 51 à 54 occupent une surface de semiconducteur importante. Par exemple, pour des transistors 501 à 516 possédant une largeur de grille (notée w5) sensiblement égale à 5 $\mu$m, on obtient une surface totale occupée par les quatre paires différentielles sensiblement égale à 280 $\mu$m$^2$.

Une telle disposition classique des transistors pour réaliser un VCO différentiel nécessite la mise en oeuvre d'un nombre élevé de pistes métalliques afin d'établir les connexions électriques des contacts des transistors nécessaires au fonctionnement du VCO.

Ainsi, une telle topologie génère, de par le nombre élevé de pistes métalliques nécessaires, des capacités parasites importantes.

On va se placer dans la suite, dans le cadre de la réalisation de VCO différentiels au moyen de technologies présentant un pas inférieur à 0,5 $\mu$m et qui fonctionnent à des fréquences supérieures à 300MHz.

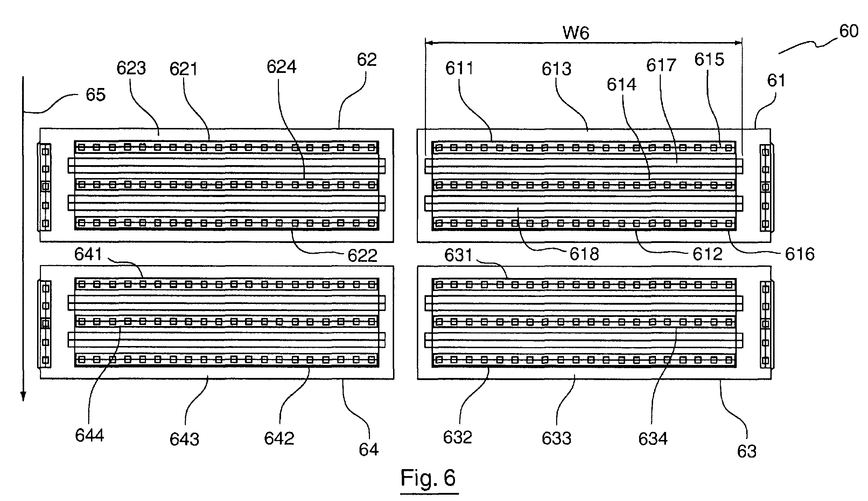

On présente en relation avec la *figure 6* un schéma de la topologie des transistors d'un VCO différentiel 60 selon un premier mode de réalisation de l'invention.

Ce VCO 60 comprend huit transistors MOS de type P 611, 621, 631, 641, 612, 622, 632, 642, formant des premiers 611, 621, 631, 641 et seconds 612, 622, 632, 642 transistors de quatre paires différentielles 61 à 64 (les autres composants du VCO 60 ne sont pas représentés sur cette figure 6).

Les deux transistors de chacune des paires différentielles 61 à 64 sont fabriqués dans un même caisson, respectivement 613, 623, 633, 643.

Les premier 611 et second 612 transistors de la paire différentielle 61 du VCO 60 possèdent chacun une source respectivement 615, 616 et une grille respectivement 617, 618.

Par soucis de simplification, nous n'avons pas représenté sur cette figure 6 les zones dopées (entourant les transistors) précédemment introduites en relation avec la figure 4.

Contrairement au VCO différentiel 50 de la figure 5, dans lequel chacune des paires différentielles, disposées en paires croisées, comprend quatre transistors, chaque paire différentielle 61 à 64 du VCO différentiel 60 selon l'invention ne comprend qu'un premier 611, 621, 631, 641 et un second 612, 622, 632, 642 transistors. Ces transistors présentent cependant une largeur de grille w6 sensiblement deux fois plus importante (par exemple w6 = 10 $\mu$m) que celle des transistors du VCO différentiel 50.

D'autre part, dans chaque paire différentielle 61 à 64 du VCO différentiel 60, les premiers 611, 621, 631, 641 et seconds 612, 622, 632, 642 transistors partagent un même unique drain respectivement 614, 624, 634, 644.

Ainsi, les quatre paires différentielles 61 à 64 de la topologie de la figure 6 occupent une surface de semiconducteur plus faible que les quatre paires différentielles disposées selon la topologie classique en « paires croisées » de la figure 5.

En effet, d'une part, dans chaque paire différentielle 61 à 64, afin de partager un drain commun 614, 624, 634, 644, les premier et second transistors sont rapprochés dans une direction horizontale 65 par rapport à la topologie classique « en paires croisées » de la figure 5.

Et d'autre part, dans le VCO différentiel 60 selon l'invention, chacun des transistors de chacune des paires différentielles, par exemple le premier transistor 611 de la paire 61, est équivalent à deux transistors d'une paire différentielle, par exemple les premier et troisième transistors 501, 503 de la paire 51, du VCO classique de la figure 5.

Ainsi, malgré le fait que les transistors du VCO différentiel 60 selon l'invention présentent une surface double par rapport à ceux de la topologie « en paires croisées », on réalise une économie de surface inter-transistor dans le VCO différentiel 60 selon l'invention.

Par exemple, pour des premiers 611, 621, 631, 641 et seconds 612, 622, 632, 642 transistors possédant une largeur de grille sensiblement égale à 10 $\mu$m, on obtient une surface totale occupée par les quatre paires différentielles sensiblement égale à 185 $\mu$m$^2$, alors que l'on a une surface de 280 $\mu$m$^2$ dans le cas de la topologie « en paires croisées ».

Par ailleurs, par rapport à la topologie classique en « paires croisées », cette topologie selon le premier mode de réalisation de l'invention permet de réduire le nombre (du fait des drains communs et du nombre réduit de transistors) et la longueur (du fait des rapprochements des transistors) des pistes métalliques nécessaires pour établir les connexions électriques du VCO différentiel 60, et donc les capacités parasites liées à ces pistes électriques.

Par exemple, selon la topologie classique en « paires croisées » (figure 5), il est nécessaire de réaliser les connexions entre les premiers 501, 505, 509, 513 et quatrièmes 504, 508, 512, 516 transistors et entre les seconds 502, 506, 510, 514 et troisième 503, 507, 511,515 transistors. Or, ces connexions donnent lieu, pour chaque paire différentielle 51 à 54, à quatre croisements de piste métallique, soit quatre capacités parasites de croisement d'environ 1,5fF chacune.

Dans la topologie selon le premier mode de réalisation de l'invention, ces connexions n'ont pas lieu d'être, ce qui permet de s'affranchir de seize capacités parasites de croisement de 1,5fF chacune par rapport à la topologie classique en « paire croisées ».

Ensuite, cette topologie selon le premier mode de réalisation de l'invention permet de réduire l'influence des capacités parasites de diffusion des transistors du VCO différentiel 60 par rapport aux capacités parasites de diffusion des transistors du VCO différentiel 50.

En effet, la capacité de diffusion Cdiffl vue par une source, pour la paire de transistors 501 et 503 selon la topologie classique en « paires croisées » de la figure 5, peut s'écrire :

$$\text{Cdiff1} = 2\text{Cja.a.b} + 2\text{Cjb.}(2a + 2b) = 2\text{Cja.a.b} + \text{Cjb.}(4a + 4b)$$

où a : longueur de la source des transistors 501 et 503, b : largeur de la source des transistors 501 et 503, Cja : capacité de jonction surfacique (exprimée en F/m$^2$), Cjb : capacité de périphérie linéique (exprimée en en F/m).

Dans le cas du premier transistor 611 (dont la longueur de la source est sensiblement égale à 2a et la largeur de la source est sensiblement égale à b) selon la topologie du premier mode de réalisation de l'invention, la capacité de diffusion CdiffDC2 vue par une source, peut s'écrire :

$$\text{Cdiff2} = 2\text{Cja.a.b} + \text{Cjb.}(4a + 2b) = 2\text{Cja.a.b} + \text{Cjb.}(4a + 2b)$$

Par exemple, Cja =1,28 10$^{-3}$ F/m$^2$ et Cjb = 3,28.10$^{-10}$ F/m.

Dans un premier exemple d'un transistor présentant une longueur de source relativement importante : a = 16 $\mu$m et b = 0,47 $\mu$m, on obtient Cdiff1 = 40,85 fF et Cdiff2 = 40,55 fF.

Dans un second exemple d'un transistor présentant une longueur de source relativement faible : a = 1 $\mu$m et

b = 0,47 $\mu$m, on obtient Cdiff1 = 3,1 fF et Cdiff2 = 2,8 fF.

En conséquence, dans le cas de transistors de petites dimensions, comme celui du second exemple précité, la topologie selon le premier mode de réalisation de l'invention permet de réduire de 10% la capacité de diffusion par rapport à la topologie en « paires croisées ».

Du fait que les transistors du VCO différentiel de la figure 6 ne sont pas disposés en « paires croisées » et qu'ils présentent de faibles dimensions (par exemple, de l'ordre de 2 $\mu$m pour la longueur des zones de diffusion des source et drain et 0,47 $\mu$m pour leur largeur), ces transistors ne présentent généralement pas des dimensions uniformes.

Ce manque d'uniformité sur les dimensions des transistors 611, 621, 631, 641, 612, 622, 632, 642 des paires différentielles 61 à 64 génère un offset entre les deux entrées de chacune des paires 61 à 64.

Cependant, contrairement à l'opinion de l'Homme du Métier, ces offsets ne nuisent pas au fonctionnement du VCO différentiel 60, au contraire, ces offsets permettent avantageusement de démarrer l'oscillateur.

Généralement, les VCO différentiels utilisent le bruit de leur alimentation pour leur démarrage (le bruit est large bande donc comprend une composante possédant la bonne fréquence qui est amplifiée et qui initie l'oscillation).

Cependant ce processus de démarrage est incertain et nécessite du temps. En effet, chaque étage d'amplification du VCO différentiel 10 de la figure 1 réagit comme un comparateur, c'est la différence de tension appliquée sur ses deux entrées différentielles qui permet de générer une tension de sortie. Dans le montage de la figure 1, les quatre étages d'amplification 11 à 14 génèrent une instabilité dans le fonctionnement du VCO 10 et donc une oscillation.

Cependant, il existe un risque que chacune des entrées des amplificateurs différentiels se trouve au même potentiel malgré la présence du bruit de l'alimentation, ce qui correspond à un point de repos du VCO et donc une absence d'oscillation. Les offsets entre les entrées de chacune des paires 61 à 64 permettent de s'affranchir de ce point de repos.

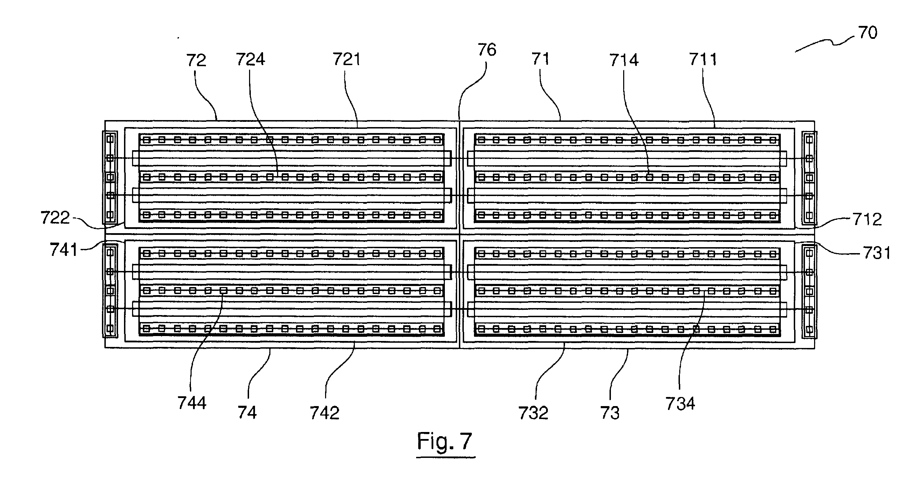

On présente en relation avec *la **figure** 7* un schéma de la topologie des transistors d'un VCO différentiel 70 selon un second mode de réalisation de l'invention.

Ce VCO 70 comprend huit transistors MOS de type P formant des premiers 711, 721, 731, 741 et seconds 712, 722, 732, 742 transistors de quatre paires différentielles 71 à 74 (les autres composants du VCO 70 ne sont pas représentés sur cette figure 7).

De la même manière que la topologie selon le premier mode de réalisation de l'invention (figure 6), dans chaque paire différentielle 71 à 74 du VCO 70, les premier 711, 721, 731, 741 et second 712, 722, 732, 742 transistors partagent un même unique drain respectivement 714, 724, 734, 744.

Contrairement à la topologie selon le premier mode de réalisation de l'invention (figure 6), dans la topologie selon ce second mode de réalisation, les quatre paires différentielles 71 à 74 sont fabriquées dans un même et unique caisson 76.

Ainsi cette topologie selon le second mode de réalisation de l'invention permet de réduire les capacités parasites liées aux pistes électriques et les capacités de diffusion des transistors par rapport à la topologie en « paires croisées » selon l'art, de la même manière que la topologie selon le premier mode de réalisation de l'invention (décrit en relation avec la figure 6).

Mais cette topologie selon le second mode de réalisation de l'invention permet en outre de réduire les capacités parasites entre le caisson et le substrat des transistors 711, 721, 731, 741, 712, 722, 732, 742. Parmi ces capacités parasites, on distingue les capacités de surface (ou « bottom capacitance » en anglais) et les capacités de périmètre (ou « sidewall capacitance » en anglais).

En effet, les capacités de surface CSURF1 et de périmètre CPERI1, pour les quatre paires différentielles 51 à 54 selon la topologie classique en « paires croisées » (mettant en oeuvre 1 caisson par paire différentielle) de la figure 5, peuvent s'écrire :

$$\text{CSURF1} = 4 \text{ H.L.Cjnwell}$$

et

$$\text{CPERI1} = 4 \text{ . } 2 \text{ (H + L).Cjswnwell}$$

où H : hauteur des caissons 571 à 574, L : longueur des caissons 571 à 574, Cjnwell : capacité surfacique drain, source / NWELL (exprimée en F/m$^2$), Cjswnwell : capacité de périmètre drain, source / NWELL (exprimée en en F/m).

Pour les quatre paires différentielles 71 à 74 selon la topologie du second mode de réalisation de l'invention mettant en oeuvre un caisson 76 unique de longueur 2L et de hauteur 2H, les capacités de surface CSURF2 et de périmètre CPERI2, peuvent s'écrire :

$$CSURF2 = 4 \; H.L.Cjnwell$$

et

$$CPERI2 = 2 \; (2H + 2L).Cjswnwell$$

Par exemple, Cjnwell = 9,55 $10^{-5}$ F/m$^2$ et Cjswnwell = 3,65.$10^{-10}$ F/m.

Par exemple, en prenant H = 3 $\mu$m et L = 2 $\mu$m, on obtient CSURF1 = 2,29 fF, CPERI1 = 14,6 fF, CSURF2 = 2,29 fF et CPERI2 = 7,3 fF.

En conséquence, la topologie selon le second mode de réalisation de l'invention permet de réduire de 50% la capacité parasite de périmètre par rapport à la topologie en « paires croisées ».

On a décrit en relation avec les figures 6 et 7, deux topologies de VCOs différentiels selon deux modes de réalisation de l'invention dans lesquels seuls des transistors de type PMOS sont mis en oeuvre. Il est à noter que l'Homme du Métier peut également mettre en oeuvre des transistors de type NMOS dans ces VCOs différentiels, et dans ce cas, dans chaque paire différentielle de ces VCOs les premier et second transistors partagent une même source et non un même drain.

Bien entendu, l'invention n'est pas limitée aux exemples de réalisation mentionnés ci-dessus.

Notamment l'invention s'applique également à tout circuit électronique comprenant au moins une paire différentielle.

En particulier, l'Homme du Métier pourra apporter toute variante dans le choix du type de transistor.


**Revendications**

1. Circuit électronique (60,70) comprenant au moins une première paire différentielle (61, 71) comprenant des premier (611, 711) et second transistors (612, 712), **caractérisé en ce que** lesdits premier et second transistors partagent une même source unique ou un même drain unique (614, 714).

2. Circuit électronique selon la revendication 1, **caractérisé en ce que** lesdits premier (611, 711) et second (612, 712) transistors sont des transistors MOS de type P et **en ce qu'**ils partagent un même drain unique (614, 714).

3. Circuit électronique selon la revendication 1, **caractérisé en ce que** lesdits premier et second transistors sont des transistors MOS de type N et **en ce qu'**ils partagent une même source unique.

4. Circuit électronique selon l'une quelconque des revendications 1 à 3, **caractérisé en ce qu'**il comprend en outre au moins une seconde paire différentielle (62, 72), l'ensemble des transistors desdites première et au moins une seconde paires différentielles étant compris dans un caisson unique (76).

5. Circuit électronique selon l'une quelconque des revendications 1 à 3, **caractérisé en ce qu'**il comprend quatre étages d'amplification comprenant chacun au moins une desdites paires différentielles (71, 72, 73, 74), l'ensemble des transistors desdites paires différentielles étant compris dans un caisson unique (76).

6. Circuit électronique selon l'une quelconque des revendications 1 à 5, **caractérisé en ce qu'**il est fabriqué au moyen d'une technologie dont le pas est inférieur à 0,5 $\mu$m.

7. Circuit électronique selon l'une quelconque des revendications 1 à 6, **caractérisé en ce qu'**il est un oscillateur différentiel commandé en tension (60, 70).

8. Circuit électronique selon la revendication 7, **caractérisé en ce qu'**il est conçu pour fonctionner à une fréquence supérieure à 300MHz.

Fig. 1

Fig. 3

Fig. 2A

Fig. 2B

Fig. 4

EP 1 677 352 A2

Fig. 5

EP 1 677 352 A2

Fig. 6

Fig. 7